# EUROPÄISCHE PATENTSCHRIFT

(11) **EP 3 232 143 B1**
(45) Veröffentlichungstag und Bekanntmachung des Hinweises auf die Patenterteilung: **01.01.2020**
(21) Anmeldenummer: 17165148.2
(22) Anmeldetag: 06.04.2017
(51) Int. Cl.: F25D 19/00

(54) **KÜHLVORRICHTUNG, UMFASSEND EINEN KRYOSTATEN UND EINEN KALTKOPF, MIT VERBESSERTER ENTKOPPLUNG ZU EINEM KÜHLSYSTEM**
COOLING DEVICE COMPRISING A CRYOSTAT AND A COOLING HEAD, WITH IMPROVED DECOUPLING FROM A COOLING SYSTEM
DISPOSITIF DE FROID COMPRENANT UN CRYOSTAT ET UNE SONDE FROIDE COMPRENANT UN DÉCOUPLAGE AMÉLIORÉ À UN SYSTÈME DE FROID

(30) Priorität: 15.04.2016 DE 102016206435
(43) Veröffentlichungstag der Anmeldung: 18.10.2017
(73) Patentinhaber: Bruker Switzerland AG, 8117 Fällanden (CH)
(72) Erfinder: Wikus, Patrick, 8309 Nürensdorf (CH); Bonn, Steffen, 8050 Zürich (CH)
(74) Vertreter: Kohler Schmid Möbus Patentanwälte

(56) Entgegenhaltungen:
- DE-A1- 19 548 273
- DE-B3-102014 214 819
- DE-B3-102014 219 849
- US-A1- 2005 229 620
- US-A1- 2015 084 633

## Beschreibung

Die Erfindung betrifft eine Kühlvorrichtung, umfassend einen Kryostaten und einen Kaltkopf eines Kühlsystems, insbesondere den Kaltkopf eines Pulsrohrkühlers,
wobei der Kryostat einen Vakuumbehälter aufweist, in welchem zumindest ein Kryobehälter für eine kryogene Flüssigkeit angeordnet ist,
wobei der Kaltkopf am Kryostaten gelagert ist und ein Kühlarm des Kaltkopfes in eine Zugangsöffnung des Kryostaten zum Kryobehälter ragt,
wobei ein flexibler Dichtungsabschnitt, der direkt oder indirekt eine Wand des Vakuumbehälters mit einem Raumtemperaturteil des Kaltkopfes verbindet, das Innere des Kryobehälters gegen die Umgebung abdichtet,
und wobei eine Verbindungsleitung für ein Arbeitsgas des Kühlsystems, insbesondere eine Druckleitung für ein pulsierendes Arbeitsgas, am Kaltkopf angeschlossen ist.

Eine solche Kühlvorrichtung ist aus der DE 10 2014 219 849 B3 bekannt geworden.

Kernspinresonanz(=NMR)-Apparaturen, insbesondere NMR-Spektrometer und NMR-Tomographen, benötigen starke Magnetfelder, die oftmals mittels supraleitender Magnetspulen erzeugt werden. Die supraleitenden Magnetspulen müssen auf einer kryogenen Temperatur betrieben werden. Die Magnetspulen sind dafür typischerweise in einem Kryobehälter eines Kryostaten angeordnet, welcher mit einer kryogenen Flüssigkeit, etwa flüssigem Helium, befüllt ist. Um langfristig die Betriebstemperatur aufrecht zu erhalten und dabei den Verbrauch von kryogenen Flüssigkeiten möglichst klein zu halten, ragt der Kühlarm eines Kaltkopfs in den Kryobehälter, mit dem Wärme entzogen werden kann. Der Kryobehälter ist zur thermischen Isolation von einem Vakuumbehälter umgeben.

Die NMR-Messungen können durch mechanische Vibrationen der NMR-Apparatur, die insbesondere über den am Kryostaten befestigten Kaltkopf eingebracht werden, gestört werden.

Bei einer Kühlung nach dem häufig zur Anwendung kommenden Pulsrohrkühlerprinzip werden im Kaltkopf periodische Druckschwankung eines Arbeitsgases eingerichtet. Ein Steuerventil schaltet dafür abwechselnd ein Hochdruckreservoir und ein Niederdruckreservoir des Arbeitsgases auf den Kaltkopf; typischerweise liegt die Umschaltfrequenz des Steuerventils bei ca. 1-2 Hz. Auch bei anderen Kühlprinzipien (beispielsweise Stirling, Gifford-MacMahon) treten am Kaltkopf störende Vibrationen auf.

Bei einer Kühlung nach dem Pulsrohrkühlerprinzip wird das Arbeitsgas üblicherweise über eine flexible Verbindungsleitung an den Kaltkopf angeschlossen, vgl. beispielsweise die EP 0 780 698 A1. Durch die flexible Verbindungsleitung wird eine Einleitung von hochfrequente Störungen in den Kaltkopf minimiert.

Die periodischen Druckschwankungen in der flexiblen Verbindungsleitung, durch die die Länge und ggf. Krümmung der flexiblen Verbindungsleitung periodisch verändert wird, können jedoch zu entsprechenden Bewegungen des Kaltkopfs führen, die in den Kryostaten eingebracht werden und die NMR-Messungen stören.

Aus der DE 10 2014 214 819 B3 ist es bekannt, bei einem Pulsrohrkühler-System zwei Leitungszweige zur Verbindung von Steuerventil und Kaltkopf einzusetzen, so dass bei denselben Druckschwankungen in beiden Zweigen gegenläufige, sich kompensierende mechanische Kräfte auftreten. Dadurch kann ein Krafteintrag in den Kaltkopf verringert werden. Der Aufbau ist jedoch relativ sperrig.

Die DE 10 2014 219 849 B3 beschreibt eine Aufhängung des Kaltkopfes an einer Kryobehälterwand mit schwingungsisolierenden Entkopplungselementen. Ein flexibler Dichtungsabschnitt zwischen Vakuumbehälterwand und Raumtemperaturteil des Kaltkopfes dichtet das Innere des Kryobehälters gegen die Umgebung ab, so dass auf beiden Seiten des flexiblen Dichtungsabschnitts nur eine minimale Druckdifferenz herrscht. In einer Ausführungsform ist eine Lagerkugel zwischen der Oberseite des Kaltkopfs und der Unterseite der Druckplatte einer Ausgleichskammer angeordnet. Der Aufbau verringert einen Kraftübertrag vom Kaltkopf auf den Kryobehälter.

Der Einsatz von schwingungsisolierenden Entkopplungselementen ist jedoch vergleichsweise teuer und erfordert bei der Justage geschultes Personal. Zudem ist die Baugröße nicht unerheblich, was den Einsatz auf kleineren Kryostaten erschwert.

### Aufgabe der Erfindung

Aufgabe der vorliegenden Erfindung ist es, einen Eintrag von mechanischen Störungen über einen Kaltkopf in einen Kryostaten, die von einem Kühlsystem ausgehen, auf einfachere und kompaktere Weise zu minimieren.

### Kurze Beschreibung der Erfindung

Diese Aufgabe wird gelöst durch eine Kühlvorrichtung der eingangs genannten Art, die dadurch gekennzeichnet ist,
dass die Kühlvorrichtung ein Drehlager aufweist, mit dem der Kaltkopf drehbar um eine Drehachse am Kryostaten gelagert ist, wobei eine Drehbewegung um die Drehachse der einzige Freiheitsgrad des Kaltkopfs am Kryostaten ist,
und dass die Verbindungsleitung so am Kaltkopf angeschlossen ist, dass durch das Kühlsystem bedingte Kräfte über die Verbindungsleitung an einem Krafteintragspunkt entlang einer Krafteintragsrichtung am Kaltkopf angreifen,
wobei die Krafteintragsrichtung gegenüber der Normalen einer Hebelebene, die die Drehachse und den Krafteintragspunkt enthält, um maximal 40° geneigt ist.

Im Rahmen der Erfindung wurde erkannt, dass die von üblichen Kühlsystemen, etwa einem Pulsrohrkühler-System, ausgehenden mechanischen Störungen bei Einleitung in den Kaltkopf in der Regel einer ausgeprägte Anisotropie unterliegen. Die Anisotropie ergibt sich im Wesentlichen aus dem Verlauf der Verbindungsleitung. Insbesondere wirken die periodischen Druckpulse des Arbeitsgases eines Pulsrohrkühler-Systems entlang der Verbindungsleitung, wobei flexible Abschnitte der Verbindungsleitung in der Regel eine Längenänderung, und bei gekrümmtem Verlauf auch eine gewisse Streckung (teilweise Entkrümmung) erfahren. Die Amplitude der Auslenkung des Kaltkopfes ist typischerweise sehr klein im Vergleich zu dessen Größe. Entsprechend gibt es am Kaltkopf einen im Wesentlichen immer gleichen Krafteintragspunkt, an welchem ein Krafteintrag in eine im Wesentlichen immer gleiche Krafteintragsrichtung erfolgt. Die mechanische Störung versucht also, dem Kaltkopf immer wieder die gleiche Bewegung aufzuprägen.

Die Erfindung sieht nun vor, die Verbindungsleitung so einzurichten bzw. den Kaltkopf so am Kryostaten zu lagern, dass der Kaltkopf diese durch die mechanische Störung bedingte, im Wesentlichen immer gleiche Bewegung gegenüber dem Kryostaten ungehindert ausführen kann.

Mit dem erfindungsgemäß vorgesehen Drehlager kann die Bewegung als Drehbewegung mit vernachlässigbarem Reibungswiderstand erfolgen. Eine weitere Entkopplung zwischen dem Kaltkopf und dem Kryostaten ist nicht nötig, und ist grundsätzlich auch nicht vorgesehen. Insbesondere werden keine Entkopplungselemente zur Lagerung am Kroystaten (etwa "negative stiffness" Isolationselemente) benötigt, und auch keine Ausgleichskammer, um bei Luftdruckschwankungen die Kaltkopfposition zu halten. Der erfindungsgemäße Lagermechanismus ist einfach aufgebaut, servicefreundlich (einfacher Ein- und Ausbau des Kaltkopfs, geringer Justageaufwand) und kompakt.

Durch die erfindungsgemäße Ausrichtung der Krafteintragsrichtung gegenüber der Normalen der Hebelebene werden die durch das Kühlsystem bedingten Kräfte (insbesondere durch Druckwellen des Arbeitsgases in einem flexiblen Leitungsabschnitt der Verbindungsleitung verursachte Stöße) großteils, bevorzugt vollständig, in eine Drehbewegung des Kaltkopfs überführt, die frei gegenüber dem Kryostaten erfolgen kann, und daher nicht als Störung in den Kryostaten eingeht. Im Rahmen der Erfindung versuchen also die durch das Kühlsystem bedingten Kräfte, den Krafteintragspunkt (entsprechend der Krafteintragsrichtung) näherungsweise entlang einer Kreisbahn um die Drehachse A (bzw. entlang einer Tangente dieser Kreisbahn am Krafteintragspunkt) zu bewegen, so dass der Kaltkopf mittels seines Drehlagers diese Bewegung einfach frei mitmachen kann. Im Betrieb der Kühlvorrichtung findet also eine gewollte, oszillierende Drehbewegung (Schaukelbewegung) des Kaltkopfs um dessen Drehachse gegenüber dem Kryostaten statt (wenngleich mit geringer Amplitude).

Der flexible Dichtungsabschnitt ist aufgrund einer minimalen Druckdifferenz (meist 0 bis 50 mbar, oft 25 mbar oder weniger) praktisch spannungsfrei und übertragt daher keine merkliche mechanische Störung auf den Kryostaten.

Soweit erforderlich oder gewünscht, können die am Kaltkopf eingehenden Kräfte bedingt durch das Kühlsystem mit bekannten Maßnahmen reduziert werden, insbesondere durch kraftkompensierende Verläufe von Leitungszweigen der Verbindungsleitung.

Bevorzugt ist die Krafteintragsrichtung gegenüber der Normalen der Hebelebene um (betragsmäßig) maximal 30°, besonders bevorzugt um maximal 15°, ganz besonders bevorzugt um maximal 10°, geneigt, oder die Krafteintragsrichtung verläuft parallel zur Normalen der Hebelebene.

### Bevorzugte Ausführungsformen der Erfindung

Besonders bevorzugt ist eine Ausführungsform einer erfindungsgemäßen Kühlvorrichtung, bei der die Drehachse durch den Schwerpunkt des Kaltkopfs verläuft. Dies vermeidet einen Krafteintrag in die Drehachse (Lagerachse) bzw. den Kryostaten beim eingerichteten Hin- und Herschwingen des Kaltkopfs. Falls in einer alternativen Ausführungsform die Drehachse nicht durch den Schwerpunkt verläuft, so sollte der Schwerpunkt unterhalb der Drehachse angeordnet sein.

Vorteilhaft ist eine Ausführungsform, bei der die Krafteintragsrichtung gegenüber einer Lagerebene, die senkrecht zur Drehachse verläuft und den Krafteintragspunkt enthält, um einen Winkel α von maximal 15°, bevorzugt von maximal 10° geneigt ist, insbesondere wobei die Krafteintragsrichtung in der Lagerebene verläuft. Dies minimiert einen Kräfteeintrag entlang der Drehachse in den Kryostaten.

Ebenfalls vorteilhaft ist eine Ausführungsform, bei der die Krafteintragsrichtung gegenüber einer Lotebene, die senkrecht zur Hebelebene sowie parallel zur Drehachse und durch den Krafteintragspunkt verläuft, um einen Winkel β von maximal 35°, bevorzugt von maximal 15° geneigt ist, insbesondere wobei die Krafteintragsrichtung in der Lotebene verläuft. Dies minimiert einen Kräfteeintrag senkrecht zur Drehachse in den Kryostaten.

Bei einer besonders bevorzugte Ausführungsform weist die Verbindungsleitung wenigstens einen flexiblen Abschnitt auf. Der flexible Abschnitt hilft, hochfrequente Störungen, die am kaltkopffernen Ende der Verbindungsleitung entstehen bzw. eingebracht werden (etwa durch ein Drehventil/Steuerventil oder einen Kompressor), nicht auf den Kaltkopf zu übertragen. Bei dieser Ausführungsform ergibt sich die Krafteintragsrichtung typischerweise aus Längenänderungen (bei gekrümmtem Verlauf auch aus Krümmungsänderungen) des wenigstens einen flexiblen Abschnitts infolge von (niederfrequenten) Druckpulsen im Arbeitsgas.

Eine vorteilhafte Weiterbildung dieser Ausführungsform sieht vor, dass der wenigstens eine flexible Abschnitt insgesamt gerade und entlang der Krafteintragsrichtung verläuft. Dadurch kann die Krafteintragsrichtung sehr einfach und präzise eingestellt werden.

Bei einer alternativen, vorteilhaften Weiterbildung ist vorgesehen, dass der wenigstens eine flexible Abschnitt zumindest in einem Teilbereich gekrümmt verläuft und/oder in verschiedenen Teilbereichen in unterschiedlichen Richtungen verläuft. Dadurch kann die Krafteintragsrichtung freier gewählt werden, und insbesondere abweichend vom Verlauf eines (dem Kaltkopf nahen) Endbereichs des flexiblen Abschnitts eingestellt werden. Oftmals ist auch ein besonders kompakter Bau möglich.

Bei einer anderen Weiterbildung ist vorgesehen, dass der Krafteintragspunkt an einem dem Kaltkopf nahen Ende des wenigstens einen flexiblen Abschnitts angeordnet ist. Dies ist in der Praxis bewährt und ergibt eine besonders einfache Bauform.

Bevorzugt ist weiterhin eine Ausführungsform, bei der die Verbindungsleitung an einem vom Kaltkopf entfernten Ende an sich bewegende Komponenten des Kühlsystems angeschlossen ist, insbesondere an ein Steuerventil oder einen Kompressor. Die sich bewegenden Komponenten können über die Verbindungsleitung entfernt vom Kryostaten positioniert werden, so dass die die Verbindungsleitung die einzige relevante mechanische Verbindung zum Kaltkopf bzw. Kryostaten darstellt, deren Krafteintrag gemäß der Erfindung vom Kryostaten auf einfache Weise ferngehalten werden kann.

Vorteilhaft ist weiterhin eine Ausführungsform der erfindungsgemäßen Kühlvorrichtung, die vorsieht, dass der Raumtemperaturabschnitt des Kaltkopfs im Bereich der Befestigung des flexiblen Dichtungsabschnitts einen Durchmesser DM senkrecht zu seiner Längsachse aufweist, und dass für einen Abstand AB der Drehachse von einer Dichtungsebene, in welcher der flexible Dichtungsabschnitt an der Wand des Vakuumbehälters befestigt ist, gilt: AB ≤ 0,4^{∗}DM, bevorzugt AB ≤ 0,3^{∗}DM,
insbesondere wobei die Drehachse in der Dichtungsebene angeordnet ist. Dadurch kann bei einem flexiblen Dichtungsabschnitt, der einen Spalt zwischen Vakuumbehälterwand und Raumtemperaturteil des Kaltkopfs radial überbrückt, eine Verformung des Dichtabschnitts bei einer Drehbewegung des Kaltkopfs im Wesentlichen axial stattfinden, was der Dichtabschnitt ohne Spannungsaufbau mitmachen kann. Der flexible Dichtabschnitt ist in der Regel in axialer Richtung ausgewölbt.

Bei einer vorteilhaften Ausführungsform sind der Kaltkopf und der Kryostat entlang einer Längsachse des Kaltkopfs gegeneinander verstellbar ausgebildet. Dadurch kann der Kaltkopf gegenüber dem Kryostaten ausgerichtet werden, insbesondere um Berührungen des Kaltkopfs am Kryostaten bei einer Drehbewegung zu vermeiden und die erforderlichen kleinen Spalte zwischen den Kühlstufen des Kaltkopfs und dem Kryostaten trotz der unvermeidlichen Fertigungstoleranzen einfach einstellen zu können. Typischerweise ist das Drehlager gegenüber dem Kryostaten fest positioniert.

Bei einer vorteilhaften Ausführungsform ist vorgesehen, dass das Drehlager mit zwei Lagerzapfen ausgebildet ist, die entlang der Drehachse von einem Kragenabschnitt des Vakuumbehälters auf den Kaltkopf zu ragen, und dass die Lagerzapfen jeweils von einem Kugellager umgriffen werden, wobei die Kugellager starr mit dem Kaltkopf verbunden sind. Um die runden Lagerzapfen können die Kugellager mit minimaler Reibung umlaufen, um die störungsbedingte Drehbewegung des Kaltkopfs gegenüber dem Kryostaten auszuführen. Die Störung wird nicht in den Kryostaten übertragen. Die Lagerzapfen können entlang der Drehachse zurückziehbar ausgebildet sein, um den Kaltkopf zu montieren oder zu demontieren.

Vorteilhaft ist weiterhin eine Weiterbildung dieser Ausführungsform, bei der die Kugellager in einem Haltering angeordnet sind, der über ein oder mehrere Verstellelemente gegenüber dem Kaltkopf entlang der Längsachse des Kaltkopfs verstellbar ist. Dadurch ist auf einfache Weise eine Verstellbarkeit des Kaltkopfs gegenüber dem Kryostaten einrichtbar. Die Verstellelemente können beispielsweise als Verstellschrauben realisiert sein. Alternativ ist es auch möglich, die Lagerzapfen verstellbar entlang der Längsachse des Kaltkopfs bzw. entlang einer Längsachse der Zugangsöffnung des Kryostaten am Kryostaten auszubilden; in diesem Fall können die Kugellager ortsfest am Kaltkopf angeordnet werden.

Eine alternative Ausführungsform sieht vor, dass das Drehlager mit zwei Lagerfortsätzen ausgebildet ist, die von einem Kragenabschnitt des Vakuumbehälters auf den Kaltkopf zu ragen, und dass die Lagerfortsätze mit mindestens zwei punktförmigen oder linienförmigen Auflagern ausgebildet sind, die auf der Drehachse A liegen. Diese Lagerung ist besonders reibungsarm, und der Kaltkopf kann einfach von oben auf die Lagerfortsätze aufgesetzt werden.

Bei einer bevorzugten Ausführungsform verläuft die Drehachse horizontal. Dadurch lässt sich der Kaltkopf gut in vertikaler Richtung von oben in einen Kryostaten hinein hängend positionieren.

In den Rahmen der vorliegenden Erfindung fällt auch eine NMR-Messanordnung, umfassend eine oben beschriebene, erfindungsgemäße Kühlvorrichtung, eine Magnetspulenanordnung im Kryobehälter sowie einen ein Probenvolumen umgebenden HF-Resonator in einer Raumtemperaturbohrung des Kryostaten. Die NMR-Messanordnung kann besonders störungsarm betrieben werden.

Weitere Vorteile der Erfindung ergeben sich aus der Beschreibung und den Zeichnungen. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Zeichnung und detaillierte Beschreibung der Erfindung

Die Erfindung ist in der Zeichnung dargestellt und wird anhand von Ausführungsbeispielen näher erläutert. Es zeigen:
- Fig. 1a: eine schematische Querschnittsdarstellung einer ersten Ausführungsform einer erfindungsgemäßen Kühlvorrichtung, mit horizontaler Verbindungsleitung;
- Fig. 1b: eine schematische Aufsicht auf den Kaltkopf der Kühlvorrichtung von Fig. 1a, mit in der Lagerebene verlaufender Verbindungsleitung;
- Fig. 1c: eine schematische Aufsicht auf einen Kaltkopf einer Kühlvorrichtung, in einer Variante mit einer schräg zur Lagerebene verlaufenden Verbindungsleitung;
- Fig. 2: eine schematische Querschnittsdarstellung einer zweiten Ausführungsform einer erfindungsgemäßen Kühlvorrichtung, mit höhenverstellbarem Kaltkopf;
- Fig. 3: eine schematische, teilweise geschnittene Schrägansicht der dritten Ausführungsform einer Kühlvorrichtung, mit Kugellager im Haltering des Kaltkopfs zum Umgreifen zweier Lagerzapfen;
- Fig. 4: eine schematische, teilweise geschnittene Schrägansicht einer vierten Ausführungsform einer erfindungsgemäßen Kühlvorrichtung, mit punktförmigen Auflagern an Lagerfortsätzen;
- Fig. 5: eine schematische Querschnittsdarstellung einer fünften Ausführungsform einer erfindungsgemäßen Kühlvorrichtung, mit einem schräg zur Horizontalen verlaufenden flexiblen Abschnitt in der Verbindungsleitung;
- Fig. 6: eine schematische Querschnittsdarstellung einer sechsten Ausführungsform einer erfindungsgemäßen Kühlvorrichtung, mit einer gekrümmt verlaufenden flexiblen Abschnitt in der Verbindungsleitung;
- Fig. 7: eine schematische Seitenansicht einer erfindungsgemäßen NMR-Messanordnung.

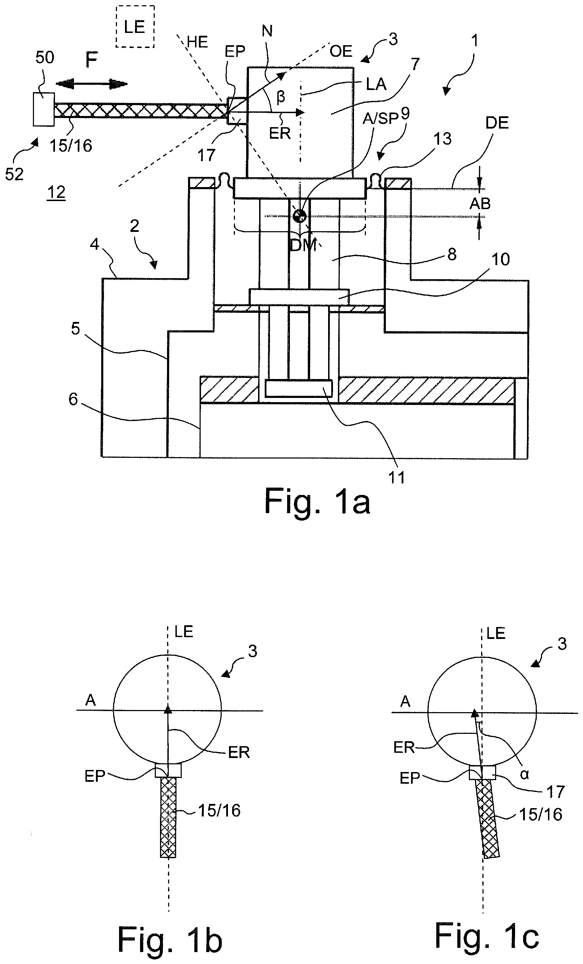

Die **Fig. 1a** zeigt in schematischer Querschnittsansicht einen Ausschnitt einer ersten Ausführungsform einer erfindungsgemäßen Kühlvorrichtung 1.

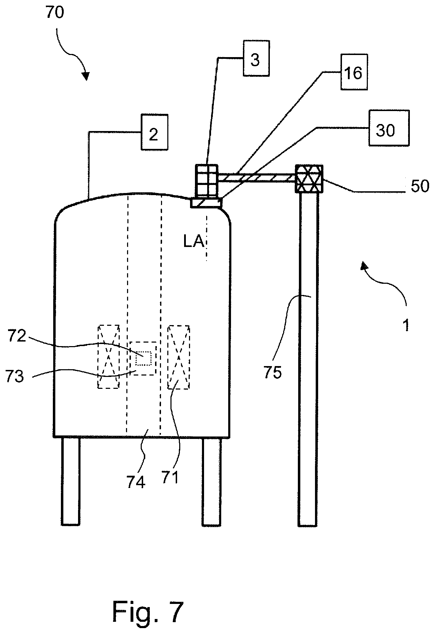

Die Kühlvorrichtung 1 umfasst eine Kryostaten 2 und einen Kaltkopf 3. Der Kryostat 2 bildet einen Vakuumbehälter 4 aus, dessen Inneres evakuiert ist. Im Vakuumbehälter 4 ist hier ein Strahlungsschild 5 ausgebildet, der einen Kryobehälter 6 umgibt. Der Kryobehälter 6 ist mit einer kryogenen Flüssigkeit, hier flüssigem Helium (nicht dargestellt) befüllt und kühlt eine im Kryobehälter 6 angeordnete supraleitende Magnetspulenanordnung (ebenfalls nicht dargestellt, vgl. hierzu aber Fig. 7) eines NMR-Spektrometers.

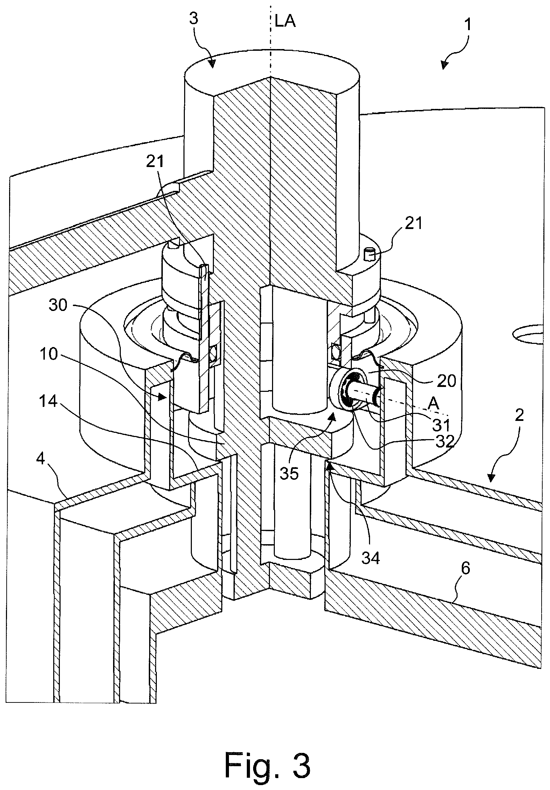

Der Kaltkopf 3 umfasst einen über den Kryostaten 2 hinausragenden Raumtemperaturteil 7 und einen Kühlarm 8, der in eine Zugangsöffnung 9 des Kryostaten 2 (hier von oben) hineinragt. In der gezeigten Ausführungsform ist eine erste Kühlstufe 10 berührungslos an den Strahlungsschild 5 gekoppelt (die kleine Beabstandung der ersten Kühlstufe 10 zur oberen Begrenzung 14 des inneren Teils des Vakuumbehälters 4 ist nicht besonders dargestellt, vgl. aber Fig. 3), und eine zweite Kühlstufe 11 des Kaltkopfs 3 ragt bis in eine obere Öffnung des Kryobehälters 6 hinein.

Die Umgebung des Kühlarms 8 ist von gasförmigem Helium umgeben, das einen geringfügig höheren Druck aufweist als die (lufterfüllte) Umgebung 12, beispielsweise einen um 20 mbar höheren Druck als die Umgebung. Ein flexibler Dichtungsabschnitt 13, der das Innere des Kryobehälters 6 gegen die Umgebung 12 abdichtet, ist am oberen Rand der Wand des Vakuumbehälters 4 und an einem unteren Rand des Raumtemperaturteils 7 des Kaltkopfs 3 befestigt. Der flexible Dichtungsabschnitt 13 ist aufgrund des geringfügig höheren Heliumdrucks innen im Vergleich zum Umgebungsdruck leicht nach außen gewölbt, steht aber unter keiner nennenswerten mechanischen Spannung.

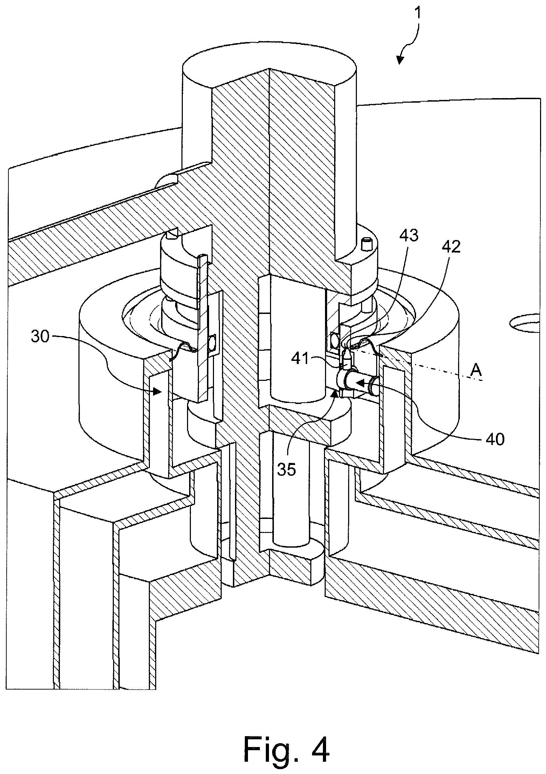

Der Kaltkopf 3 ist über ein Drehlager (nicht näher dargestellt, vgl. dazu aber Figs. 3, 4) am Kryostaten 2 gelagert. Der Kaltkopf 3 ist entsprechend um eine Drehachse A gegenüber dem Kryostaten 2 frei drehbar; in der gezeigten Stellung ist der Kaltkopf 3 mit seiner Längsachse LA parallel zur Vertikalen ausgerichtet (vertikale Lage). Allerdings ist der maximale Drehwinkel des Kaltkopfs 3 auf einen engen Winkelbereich um seine mittlere Lage (hier vertikale Lage) begrenzt, typischerweise auf +/- 5° oder weniger, bevor der Kaltkopf 3 an den Kryostaten 2 (etwa den Rand der Öffnung des Kryobehälters 6) stößt. Die Drehachse A verläuft hier durch den Schwerpunkt SP des Kaltkopfs 3.

Der Kaltkopf 3 ist Teil eines Kühlsystems 52, nämlich eines Pulsrohrkühlers. Von einem Steuerventil 50 aus wird über eine Verbindungsleitung 15 abwechselnd (bei ca. 1-2 Hz) ein hoher Druck und ein niedriger Druck eines Arbeitsgases (meist Helium) an den Kaltkopf 3 angelegt. Die Verbindungsleitung 15 kommt in der gezeigten Ausführungsform mit einem gerade horizontal verlaufenden, flexiblen Leitungsabschnitt 16 an einem Flansch 17 am Kaltkopf 3 an. Die Druckschwankungen verursachen im Wechsel Ausdehnungen und Verkürzungen des flexiblen Leitungsabschnitts 16 in seiner Längsrichtung, was im Wechsel Druckkraft und Zugkraft am Anschluss des flexiblen Leitungsabschnitts 16 am Kaltkopf 3 verursacht.

Durch die Druckstöße des Arbeitsgases wirkt entsprechend periodisch entlang einer Krafteintragsrichtung ER eine Kraft an einem Krafteintragspunkt EP auf den Kaltkopf 3 ein.

Die Krafteintragsrichtung ER schließt einen Winkel γ mit einer Normalen N auf einer Hebelebene HE ein. Die Normale steht senkrecht auf der Hebelebene; ein Endpunkt der Normalen N ist auf den Krafteintragspunkt EP gelegt. Die Hebelebene HE enthält die Drehachse A und den Krafteintragspunkt EP.

In der gezeigten Ausführungsform liegt die Krafteintragsrichtung ER in einer Lagerebene LE. Die Lagerebene LE verläuft senkrecht zur Drehachse A und enthält den Krafteintragspunkt EP. Daher ist der Winkel γ hier gleich einem Winkel β, der zwischen der Krafteintragsrichtung ER und einer Lotebene OE gemessen wird, wobei die Lotebene OE senkrecht zur Hebelebene HE sowie parallel zur Drehachse A verläuft und den Krafteintragspunkt EP enthält. Man beachte, dass die Lotebene OE weiterhin senkrecht zur Lagerebene LE ist.

Der Winkel γ bzw. β beträgt in der gezeigten Ausführungsform ca. 30°, so dass der größte Teil der Krafteinwirkung entlang der Richtung der Normalen N wirkt. Aufgrund des Drehlagers kann der Kaltkopf 3, diesem größten Teil der Krafteinwirkung folgend, eine Drehbewegung gegenüber dem Kryostaten 2 um die Drehachse A ausführen. Da die Drehbewegung frei erfolgt, wird dadurch keine Kraft über das Drehlager in den Kryostaten 3 eingebracht.

Man beachte, dass durch kleinere Winkel γ der Krafteintragsrichtung ER gegenüber der Normalen N der Hebelebene HE verbleibende, über das Drehlager auf den Kryostaten 3 wirkende Kräfte weiter verringert werden können; bevorzugt wird daher der Winkel γ möglichst klein gewählt.

Ein Abstand AB der Drehachse A von einer Dichtungsebene DE, in welcher der flexible Leitungsabschnitt 13 an der Wand des Vakuumbehälters 4 (direkt oder indirekt) befestigt ist, sollte klein im Vergleich zum Durchmesser DM des Raumtemperaturteils 7 des Kaltkopfs 3 sein, wo der flexible Leitungsabschnitt 13 am Raumtemperaturteil 7 befestigt ist, oder auch im Vergleich zum Durchmesser DM des Raumtemperaturteils 7 in der Dichtungsebene DE. Vorliegend ist AB zu ca. 0,2^{∗}DM gewählt. Dadurch werden die Ränder des Raumtemperaturteils 7, wo der flexible Dichtungsabschnitt 13 befestigt ist, bei der Drehbewegung im Wesentlichen nur axial gehoben oder gesenkt, und nur minimal vertikal verfahren, wodurch der flexible Dichtungsabschnitt 13 gut spannungsfrei gehalten werden kann.

Die **Fig. 1b** zeigt eine Aufsicht auf den Kaltkopf 3 von Fig. 1a. Wie gut zu erkennen ist, verläuft der flexible Abschnitt 16 der Verbindungsleitung 15 in der Lagerebene LE, und ein Winkel α zwischen der Lagerebene LE und der Krafteintragsrichtung ER ist hier 0°. Dadurch wird ein Krafteintrag in den Kryostaten entlang der Drehachse (Lagerachse) A vermieden.

Falls die Krafteintragsrichtung ER einen nicht verschwindenden Winkel α mit der Lagerebene LE einschließt, vgl. **Fig. 1c****,** etwa weil der flexible Abschnitt 16 der Verbindungsleitung 15 schräg am Flansch 17 des Kaltkopfs 3 ankommt, kann es zu einem gewissen Krafteintrag entlang der Drehachse A in den Kryostaten kommen. Daher wird der Winkel α möglichst klein gewählt, um diesen Krafteintrag zu minimieren.

Man beachte, dass der Winkel γ zur Normalen der Hebelebene einen Beitrag aus α und einen Beitrag aus β haben kann.

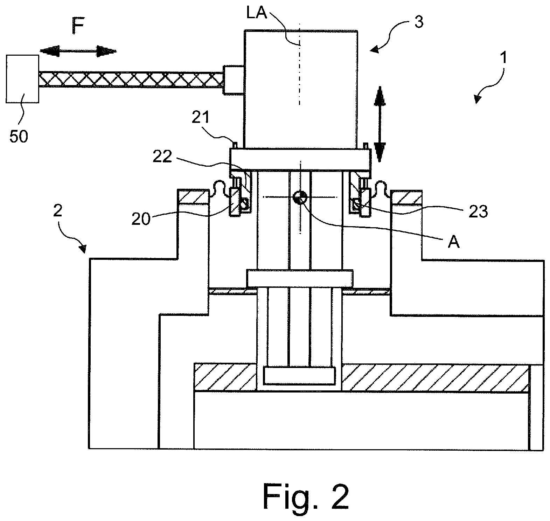

**Fig. 2** illustriert eine zweite Ausführungsform einer erfindungsgemäßen Kühlvorrichtung 1, ähnlich zur ersten Ausführungsform von Fig. 1, so dass nur die wesentlichen Unterschiede erläutert werden.

Die Kühlvorrichtung 1 ist hier mit einem Haltering 20 ausgebildet, der drehbar um die Drehachse A am Kryostaten 2 gelagert ist. Am Haltering 20 ist der (übrige) Kaltkopf 3 entlang der Längsachse LA, hier im Wesentlichen vertikal, verstellbar über Stellschrauben 21 befestigt. An der Innenseite des Halterings 20 ist ein Kragen 22 des Kaltkopfs 2 ausgebildet, der mit einem O-Ring 23 gegenüber dem Haltering 20 abgedichtet ist. Bei vertikaler Verstellung des Kaltkopfes 2 gegenüber dem Haltering 20 kann der O-Ring 23 an der Innenseite des Halterings 20 abgleiten.

Durch die Verstellbarkeit kann der Schwerpunkt des Kaltkopfs 3 gegenüber der (ortsfesten) Drehachse A, oder auch die Position des Kaltkopfs 3 gegenüber dem Kryostaten 2 zur Vermeidung von gegenseitigem Kontakt eingestellt werden.

**Fig. 3** zeigt in einer schematischen, teilweise geschnittenen Ansicht eine dritte Ausführungsform einer erfindungsgemäßen Kühlvorrichtung 1, ähnlich der Ausführungsform von Fig. 2, so dass nur die wesentlichen Unterschiede erläutert werden. Bei dieser Ansicht kann das Drehlager 35 für den Kaltkopf 3 gut erkannt werden.

Von einem Kragenabschnitt 30 des Vakuumbehälters 4 ragen zwei gegenüberliegende, im Querschnitt kreisförmige Lagerzapfen 31 (in Fig. 3 ist davon nur einer sichtbar) nach innen auf den Kaltkopf 3 zu. Die Lagerzapfen 31 verlaufen entlang der Drehachse A. Die Lagerzapfen 31 werden jeweils von einem Kugellager 32 umgriffen. Die Kugellager 32 sind in einem Haltering 20 ausgebildet, an dem der Kaltkopf 3 gelagert ist. Der Haltering 20 kann dabei relativ zum Kaltkopf 3 mittels mehrerer Stellschrauben 21 entlang der Längsachse LA des Kaltkopfs 3 verfahren werden. Ein Kragen 22 des Kaltkopfs 3 mit einem O-Ring 23 dichtet dabei den Kaltkopf 3 für gasförmiges Helium aus dem Kryobehälter 6 ab.

In Fig. 3 ist auch gut ein Spalt 34 zwischen der ersten Kühlstufe 10 und der oberen Begrenzung 14 des inneren Teils des Vakuumbehälters 4 zu erkennen.

**Fig. 4** zeigt in einer schematischen, teilweise geschnittenen Ansicht eine vierte Ausführungsform einer erfindungsgemäßen Kühlvorrichtung 1, ähnlich der Ausführungsform von Fig. 3, so dass nur die wesentlichen Unterschiede erläutert werden.

Das Drehlager 35 ist hier mit zwei gegenüberliegenden Lagerfortsätzen 40 (von denen nur einer in Fig. 4 sichtbar ist) ausgebildet, die von einem Kragenabschnitt 30 nach innen abstehen. Die Lagerfortsätze 40 sind im Wesentlichen L-förmig ausgebildet, wobei hier jeweils am oberen Ende von kegelförmigen Vertikalstreben 41 punktförmige Auflager 42 ausgebildet sind. Die Auflager 42 sitzen in näherungsweise kegelförmigen, nach unten offenen Ausnehmungen 43 im Haltering 20 auf. Dadurch kann der Kaltkopf 3 um die Drehachse A, die durch die punktförmigen Auflager 42 verläuft, verschwenkt bzw. gedreht werden.

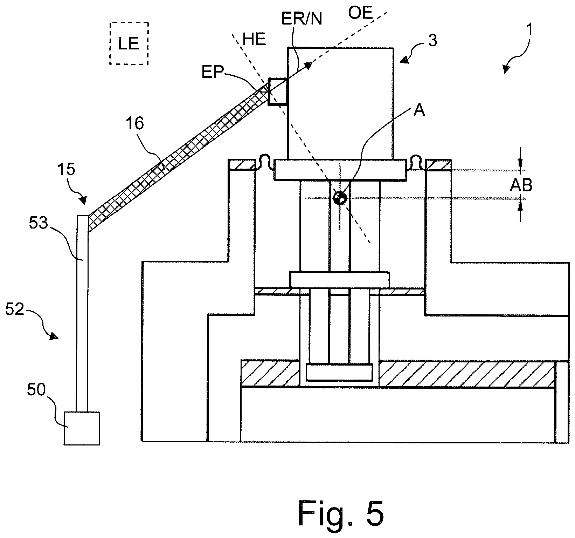

**Fig. 5** zeigt eine fünfte Ausführungsform einer erfindungsgemäßen Kühlvorrichtung 1, die weitgehend der Ausführungsform von Fig. 1a entspricht, so dass nachfolgend nur die wesentlichen Unterschiede erläutert werden.

Bei dieser Ausführungsform umfasst die Verbindungsleitung 15 einen starren Abschnitt 53 und einen flexiblen Abschnitt 16. Der flexible Abschnitt 16 verläuft schräg zur Horizontalen. Dadurch kann er näherungsweise senkrecht zur Hebelebene HE eingerichtet werden. Druckbedingte Verlängerungen und Verkürzungen des flexiblen Abschnitts 16, ausgelöst durch das Steuerventil (Drehventil) 50 des Kühlsystems 52 (hier ein Pulsrohrkühlersystem), verursacht dann eine Kraft auf den Kaltkopf 3 in Krafteintragsrichtung ER, die entlang der Normalen N der Hebelebene HE verläuft. Die Krafteintragsrichtung ER schließt somit einen Winkel von β=0° mit der Lotebene OE ein.

Der Winkel α der Krafteintragsrichtung ER zur Lagerebene LE beträgt hier ebenfalls 0° (nicht näher dargestellt), so dass durch das Kühlsystem 52 praktisch keine Kräfte über das Drehlager in den Kryostaten 2 eingebracht werden.

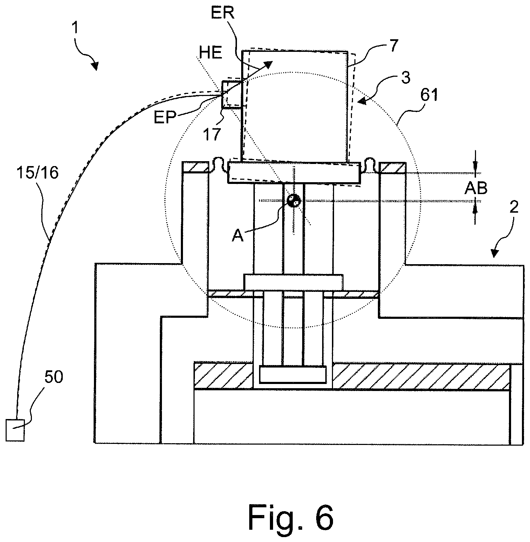

Die **Fig. 6** zeigt eine sechste Ausführungsform einer erfindungsgemäßen Kühlvorrichtung 1, ähnlich zur Ausführungsform von Fig. 1a, so dass nur die wesentlichen Unterschiede erläutert werden.

Die Verbindungsleitung 15 verläuft hier mit einem gekrümmten flexiblen Abschnitt 16 vom Steuerventil 50 zum Flansch 17 des Kaltkopfs 3. Durch Druckpulse des Arbeitsgases im flexiblen Abschnitt 16 wird dieser nicht nur verlängert (und verkürzt), sondern auch gestreckt, das heißt die Krümmung wird verringert. Dadurch weicht die Krafteintragsrichtung ER von der Verlaufsrichtung des kaltkopfnahen Endes des flexiblen Abschnitts 16 ab.

Der flexible Abschnitt 16 wird bevorzugt so eingerichtet (insbesondere bezüglich seiner axialen Steifigkeit und seiner Krümmung), dass infolge der Druckpulse der Endpunkt des flexiblen Leitungsabschnitts 16, der dem Krafteintragspunkt EP entspricht, auf einer Kreisbahn 61 um die Achse A (oder näherungsweise auf einer Tangente dieser Kreisbahn) geführt würde, auch wenn der Endpunkt nicht am Kaltkopf 3 befestigt wäre ("tangentiale Krafteintragsrichtung"). Nach Befestigung des flexiblen Anschnitts 16 am Kaltkopf 3 wird der Kaltkopf 3 dann durch die Krafteinwirkung der Druckpulse lediglich frei um die Drehachse A gedreht, und es werden näherungsweise keine Kräfte über das Drehlager auf den Kryostaten 2 übertragen. Die Krafteintragsrichtung ER verläuft dann wiederum entlang der Normalen der Hebelebene HE, ausgehend vom Krafteintragspunkt EP.

In der Fig. 6 ist eine verdrehte Position des Raumtemperaturteils 7 des Kaltkopfs 3 und die zugehörige gestreckte Stellung des flexiblen Leitungsabschnitts 16 gestrichelt eingezeichnet.

Eine ähnliche mechanische Wirkung wie durch einen gekrümmten flexiblen Abschnitt der Verbindungsleitung kann auch durch zwei gerade verlaufende, zueinander schräge, hintereinander eingesetzte flexible Leitungsabschnitte erzielt werden (nicht näher dargestellt).

Die **Fig. 7** zeigt in einer schematischen Seitenansicht eine erfindungsgemäße NMR-Messanordnung 70, hier ein hochauflösendes NMR-Spektrometer, in der eine erfindungsgemäße Kühlvorrichtung 1, wie etwa in Fig. 1a dargestellt, verbaut ist. Diese umfasst einen Kryostaten 2, in dessen Kryobehälter (nicht näher dargestellt) eine supraleitende Magnetspulenanordnung 71 untergebracht ist. Diese erzeugt in einem Probenvolumen 72 ein homogenes statisches Magnetfeld B₀. Über einen HF-Resonator 73 können in das Probenvolumen 72 bzw. eine dort angeordnete Probe HF-Pulse eingestrahlt werden, und die resultierenden, von der Probe ausgehenden Signale detektiert werden. Das Probenvolumen 72 und der HF-Resonator 73 sind in einer hier vertikalen Raumtemperaturbohrung 74 des Kryostaten 2 angeordnet. Eine kryogene Flüssigkeit im Kryobehälter des Kryostaten 2 wird mittels eines einragenden, drehbar gelagerten Kaltkopfs 3 gekühlt, der über den flexiblen Abschnitt 16 einer Verbindungsleitung mit einem Steuerventil 50 verbunden ist, das hier auf einer starren Stütze 75 angeordnet ist. Über das Steuerventil 50 wird abwechselnd ein Hochdruckreservoir und ein Niederdruckreservoir eines Arbeitsgases auf den Kaltkopf 3 nach dem Pulsrohrkühlerprinzip geschaltet.

## Patentansprüche

1. Kühlvorrichtung (1), umfassend einen Kryostaten (2) und einen Kaltkopf (3) eines Kühlsystems (52), insbesondere den Kaltkopf (3) eines Pulsrohrkühlers,
wobei der Kryostat (2) einen Vakuumbehälter (4) aufweist, in welchem zumindest ein Kryobehälter (6) für eine kryogene Flüssigkeit angeordnet ist,
wobei der Kaltkopf (3) am Kryostaten (2) gelagert ist und ein Kühlarm (8) des Kaltkopfes (3) in eine Zugangsöffnung (9) des Kryostaten (2) zum Kryobehälter (6) ragt,
wobei ein flexibler Dichtungsabschnitt (13), der direkt oder indirekt eine Wand des Vakuumbehälters (4) mit einem Raumtemperaturteil (7) des Kaltkopfes (3) verbindet, das Innere des Kryobehälters (6) gegen die Umgebung (12) abdichtet,
und wobei eine Verbindungsleitung (15) für ein Arbeitsgas des Kühlsystems (52), insbesondere eine Druckleitung für ein pulsierendes Arbeitsgas, am Kaltkopf (3) angeschlossen ist,
**dadurch gekennzeichnet,**
**dass** die Kühlvorrichtung (1) ein Drehlager (35) aufweist, mit dem der Kaltkopf (3) drehbar um eine Drehachse (A) am Kryostaten (2) gelagert ist, wobei eine Drehbewegung um die Drehachse (A) der einzige Freiheitsgrad des Kaltkopfs (3) am Kryostaten (2) ist,
und **dass** die Verbindungsleitung (15) so am Kaltkopf (3) angeschlossen ist, dass durch das Kühlsystem (52) bedingte Kräfte über die Verbindungsleitung (15) an einem Krafteintragspunkt (EP) entlang einer Krafteintragsrichtung (ER) am Kaltkopf (3) angreifen, wobei die Krafteintragsrichtung (ER) gegenüber der Normalen (N) einer Hebelebene (HE), die die Drehachse (A) und den Krafteintragspunkt (EP) enthält, um maximal 40° geneigt ist.

2. Kühlvorrichtung (1) nach Anspruch 1, **dadurch gekennzeichnet, dass** die Drehachse (A) durch den Schwerpunkt (SP) des Kaltkopfs (3) verläuft.

3. Kühlvorrichtung (1) nach einem der vorhergehenden Ansprüche, **dadurch gekennzeichnet, dass** die Krafteintragsrichtung (ER) gegenüber einer Lagerebene (LE), die senkrecht zur Drehachse (A) verläuft und den Krafteintragspunkt (EP) enthält, um einen Winkel α von maximal 15°, bevorzugt von maximal 10° geneigt ist,
insbesondere wobei die Krafteintragsrichtung (ER) in der Lagerebene (LE) verläuft.

4. Kühlvorrichtung (1) nach einem der vorhergehenden Ansprüche, **dadurch gekennzeichnet, dass** die Krafteintragsrichtung (ER) gegenüber einer Lotebene (OE), die senkrecht zur Hebelebene (HE) sowie parallel zur Drehachse (A) und durch den Krafteintragspunkt (EP) verläuft, um einen Winkel β von maximal 35°, bevorzugt von maximal 15° geneigt ist, insbesondere wobei die Krafteintragsrichtung (ER) in der Lotebene (OE) verläuft.

5. Kühlvorrichtung (1) nach einem der vorhergehenden Ansprüche, **dadurch gekennzeichnet, dass** die Verbindungsleitung (15) wenigstens einen flexiblen Abschnitt (16) aufweist.

6. Kühlvorrichtung (1) nach Anspruch 5, **dadurch gekennzeichnet, dass** der wenigstens eine flexible Abschnitt (16) insgesamt gerade und entlang der Krafteintragsrichtung (ER) verläuft.

7. Kühlvorrichtung (1) nach Anspruch 5, **dadurch gekennzeichnet, dass** der wenigstens eine flexible Abschnitt (16) zumindest in einem Teilbereich gekrümmt verläuft und/oder in verschiedenen Teilbereichen in unterschiedlichen Richtungen verläuft.

8. Kühlvorrichtung (1) nach einem der Ansprüche 5 bis 7, **dadurch gekennzeichnet, dass** der Krafteintragspunkt (EP) an einem dem Kaltkopf (3) nahen Ende des wenigstens einen flexiblen Abschnitts (16) angeordnet ist.

9. Kühlvorrichtung (1) nach einem der vorhergehenden Ansprüche, **dadurch gekennzeichnet, dass** die Verbindungsleitung (15) an einem vom Kaltkopf (3) entfernten Ende an sich bewegende Komponenten des Kühlsystems (52) angeschlossen ist, insbesondere an ein Steuerventil (50) oder einen Kompressor.

10. Kühlvorrichtung (1) nach einem der vorhergehenden Ansprüche, **dadurch gekennzeichnet, dass** der Raumtemperaturabschnitt (7) des Kaltkopfs (3) im Bereich der Befestigung des flexiblen Dichtungsabschnitts (13) einen Durchmesser DM senkrecht zu seiner Längsachse (LA) aufweist, und dass für einen Abstand AB der Drehachse (A) von einer Dichtungsebene (DE), in welcher der flexible Dichtungsabschnitt (13) an der Wand des Vakuumbehälters (4) befestigt ist, gilt:
AB ≤ 0,4^{∗}DM, bevorzugt AB ≤ 0,3^{∗}DM,
insbesondere wobei die Drehachse (A) in der Dichtungsebene (DE) angeordnet ist.

11. Kühlvorrichtung (1) nach einem der vorhergehenden Ansprüche, **dadurch gekennzeichnet, dass** der Kaltkopf (3) und der Kryostat (2) entlang einer Längsachse (LA) des Kaltkopfs (3) gegeneinander verstellbar ausgebildet sind.

12. Kühlvorrichtung (1) nach einem der Ansprüche 1 bis 11, **dadurch gekennzeichnet, dass** das Drehlager (35) mit zwei Lagerzapfen (31) ausgebildet ist, die entlang der Drehachse (A) von einem Kragenabschnitt (30) des Vakuumbehälters (4) auf den Kaltkopf (3) zu ragen, und dass die Lagerzapfen (31) jeweils von einem Kugellager (32) umgriffen werden, wobei die Kugellager (32) starr mit dem Kaltkopf (3) verbunden sind.

13. Kühlvorrichtung (1) nach Anspruch 11 und 12, **dadurch gekennzeichnet, dass** die Kugellager (32) in einem Haltering (20) angeordnet sind, der über ein oder mehrere Verstellelemente (21) gegenüber dem Kaltkopf (3) entlang der Längsachse (LA) des Kaltkopfs (3) verstellbar ist.

14. Kühlvorrichtung (1) nach einem der Ansprüche 1 bis 11, **dadurch gekennzeichnet, dass** das Drehlager (35) mit zwei Lagerfortsätzen (40) ausgebildet ist, die von einem Kragenabschnitt (30) des Vakuumbehälters (4) auf den Kaltkopf (3) zu ragen, und dass die Lagerfortsätze (40) mit mindestens zwei punktförmigen oder linienförmigen Auflagern (42) ausgebildet sind, die auf der Drehachse (A) liegen.

15. Kühlvorrichtung (1) nach einem der vorhergehenden Ansprüche, **dadurch gekennzeichnet, dass** die Drehachse (A) horizontal verläuft.

16. NMR-Messanordnung (70), umfassend eine Kühlvorrichtung (1) nach einem der vorhergehenden Ansprüche, eine Magnetspulenanordnung (71) im Kryobehälter (6) sowie einen ein Probenvolumen (72) umgebenden HF-Resonator (73) in einer Raumtemperaturbohrung (74) des Kryostaten (2).

## Claims

1. A cooling device (1) comprising a cryostat (2) and a cold head (3) of a cooling system (52), in particular the cold head (3) of a pulse tube refrigerator,
the cryostat (2) comprising a vacuum tank (4) in which at least one cryogen tank (6) for a cryogenic liquid is arranged,
the cold head (3) being mounted on the cryostat (2), and a cooling arm (8) of the cold head (3) projecting into an access opening (9) of the cryostat (2) to the cryogen tank (6),
a flexible sealing element (13), which directly or indirectly connects a wall of the vacuum tank (4) to a room temperature part (7) of the cold head (3), sealing off the inside of the cryogen tank (6) from the environment (12),
and a connecting line (15) for a working gas of the cooling system (52), in particular a pressure line for a pulsating working gas, being connected to the cold head (3),
**characterized in that**
the cooling device (1) comprises a pivot bearing (35), by means of which the cold head (3) is mounted on the cryostat (2) so as to be rotatable about a rotation axis (A), wherein a rotational movement about the rotation axis (A) is the only degree of freedom of the cold head (3) on the cryostat (2),
and **in that** the connecting line (15) is connected to the cold head (3) in such a way that forces caused by the cooling system (52) act on the cold head (3) via the connecting line (15) at a force application point (EP) in a force application direction (ER), the force application direction (ER) being inclined by no more than 40° with respect to the normal (N) of a lever plane (HE) which contains the rotation axis (A) and the force application point (EP).

2. The cooling device (1) according to claim 1, **characterized in that** the rotation axis (A) extends through the center of gravity (SP) of the cold head (3).

3. The cooling device (1) according to any of the preceding claims, **characterized in that** the force application direction (ER) is inclined by an angle α of no more than 15°, preferably of no more than 10°, with respect to a bearing plane (LE) which extends perpendicularly to the rotation axis (A) and contains the force application point (EP),
the force application direction (ER) in particular extending in the bearing plane (LE).

4. The cooling device (1) according to any of the preceding claims, **characterized in that** the force application direction (ER) is inclined by an angle β of no more than 35°, preferably of no more than 15°, with respect to a plummet plane (OE) which extends perpendicularly to the lever plane (HE) and parallel to the rotation axis (A) and through the force application point (EP),
the force application direction (ER) in particular extending in the plummet plane (OE).

5. The cooling device (1) according to any of the preceding claims, **characterized in that** the connecting line (15) comprises at least one flexible portion (16).

6. The cooling device (1) according to claim 5, **characterized in that** the at least one flexible portion (16) extends overall in a straight line and in the force application direction (ER).

7. The cooling device (1) according to claim 5, **characterized in that** the at least one flexible portion (16) is curved at least in one subportion and/or extends in different directions in different subportions.

8. The cooling device (1) according to any of claims 5 to 7, **characterized in that** the force application point (EP) is arranged at an end of the at least one flexible portion (16) that is close to the cold head (3).

9. The cooling device (1) according to any of the preceding claims, **characterized in that** the connecting line (15) is connected, at an end remote from the cold head (3), to moving components of the cooling system (52), in particular to a control valve (50) or a compressor.

10. The cooling device (1) according to any of the preceding claims, **characterized in that** the room temperature part (7) of the cold head (3) has a diameter DM perpendicular to its longitudinal axis (LA) in the region where the flexible sealing element (13) is attached, and that the following applies for a spacing AB of the rotation axis (A) from a sealing plane (DE) in which the flexible sealing element (13) is attached to the wall of the vacuum tank (4):
AB ≤ 0.4^{∗}DM, preferably AB ≤ 0.3^{∗}DM,
the rotation axis (A) in particular being arranged in the sealing plane (DE).

11. The cooling device (1) according to any of the preceding claims, **characterized in that** the cold head (3) and the cryostat (2) are designed so as to be mutually adjustable along a longitudinal axis (LA) of the cold head (3).

12. The cooling device (1) according to any of claims 1 to 11, **characterized in that** the pivot bearing (35) is designed having two bearing pins (31) which project along the rotation axis (A) from a collar portion (30) of the vacuum tank (4) towards the cold head (3), and **in that** the bearing pins (31) are each surrounded by a ball bearing (32), the ball bearings (32) being rigidly connected to the cold head (3).

13. The cooling device (1) according to claims 11 and 12, **characterized in that** the ball bearings (32) are arranged in a retaining ring (20) which is adjustable with respect to the cold head (3) along the longitudinal axis (LA) of the cold head (3) by means of one or more adjusting elements (21).

14. The cooling device (1) according to any of claims 1 to 11, **characterized in that** the pivot bearing (35) is designed having two bearing extensions (40) which project from a collar portion (30) of the vacuum tank (4) towards the cold head (3), and **in that** the bearing extensions (40) are designed having at least two point-shaped or line-shaped supports (42) which lie on the rotation axis (A).

15. The cooling device (1) according to any of the preceding claims, **characterized in that** the rotation axis (A) extends horizontally.

16. An NMR measurement assembly (70), comprising a cooling device (1) according to any of the preceding claims, a magnet coil assembly (71) in the cryogen tank (6), and an RF resonator (73) surrounding a sample volume (72) in a room temperature bore (74) of the cryostat (2).

## Revendications

1. Dispositif de refroidissement (1) comprenant un cryostat (2) et une tête froide (3) d'un système de refroidissement (52), en particulier la tête froide (3) d'un refroidisseur à tube pulsé,
le cryostat (2) comportant un réservoir (4) à dépression dans lequel se trouve au moins un conteneur cryogénique (6) dédié à un liquide cryogénique,
la tête froide (3) étant montée sur ledit cryostat (2), et un bras refroidisseur (8) de ladite tête froide (3) faisant saillie vers le conteneur cryogénique (6), dans un orifice d'accès (9) dudit cryostat (2),
sachant qu'une zone flexible d'étanchement (13), reliant directement ou indirectement une paroi du réservoir (4) à dépression à une partie (7) à température ambiante de la tête froide (3), assure l'étanchéité de l'espace interne du conteneur cryogénique (6) vis-à-vis de l'espace environnant (12),
et sachant qu'un conduit de jonction (15) destiné à un gaz de travail du système de refroidissement (52), en particulier un conduit de pression dévolu à un gaz de travail pulsé, est raccordé à la tête froide (3),
**caractérisé par le fait**
**que** ledit dispositif de refroidissement (1) est muni d'un palier tournant (35) par lequel la tête froide (3) est montée à rotation sur le cryostat (2), autour d'un axe de rotation (A), un mouvement rotatoire, autour dudit axe de rotation (A), constituant l'unique degré de liberté de ladite tête froide (3) sur ledit cryostat (2) ;
et par le fait que le conduit de jonction (15) est raccordé à ladite tête froide (3) de façon telle que des forces, conditionnées par le système de refroidissement (52), soient appliquées à ladite tête froide (3) par l'intermédiaire dudit conduit de jonction (15), en un point (EP) d'introduction de forces le long d'une direction (ER) d'introduction de forces, laquelle direction (ER) d'introduction de forces est inclinée, au maximum, de 40° vis-à-vis de la normale (N) à un plan de levier (HE) contenant l'axe de rotation (A) et ledit point (EP) d'introduction de forces.

2. Dispositif de refroidissement (1) selon la revendication 1, **caractérisé par le fait que** l'axe de rotation (A) passe par le centre de gravité (SP) de la tête froide (3).

3. Dispositif de refroidissement (1) selon l'une des revendications précédentes, **caractérisé par le fait que** la direction (ER) d'introduction de forces est inclinée d'un angle α de 15° au maximum, préférentiellement de 10° au maximum par rapport à un plan de support (LE) s'étendant perpendiculairement à l'axe de rotation (A) et contenant le point (EP) d'introduction de forces,
sachant notamment que ladite direction (ER) d'introduction de forces s'étend dans ledit plan de support (LE).

4. Dispositif de refroidissement (1) selon l'une des revendications précédentes, **caractérisé par le fait que** la direction (ER) d'introduction de forces est inclinée d'un angle β de 35° au maximum, préférentiellement de 15° au maximum par rapport à un plan d'aplomb (OE) s'étendant perpendiculairement au plan de levier (HE), ainsi que parallèlement à l'axe de rotation (A), et passant par le point (EP) d'introduction de forces, sachant notamment que ladite direction (ER) d'introduction de forces s'étend dans ledit plan d'aplomb (OE).

5. Dispositif de refroidissement (1) selon l'une des revendications précédentes, **caractérisé par le fait que** le conduit de jonction (15) est pourvu d'au moins un tronçon flexible (16).

6. Dispositif de refroidissement (1) selon la revendication 5, **caractérisé par le fait que** le tronçon flexible (16), à présence minimale, s'étend globalement en ligne droite et le long de la direction (ER) d'introduction de forces.

7. Dispositif de refroidissement (1) selon la revendication 5, **caractérisé par le fait que** le tronçon flexible (16), à présence minimale, décrit un tracé curviligne au moins dans une région partielle et/ou s'étend dans des directions différentes dans différentes régions partielles.

8. Dispositif de refroidissement (1) selon l'une des revendications 5 à 7, **caractérisé par le fait que** le point (EP) d'introduction de forces se trouve à une extrémité du tronçon flexible (16), à présence minimale, qui est située à proximité de la tête froide (3).

9. Dispositif de refroidissement (1) selon l'une des revendications précédentes, **caractérisé par le fait que** le conduit de jonction (15) est raccordé, à une extrémité éloignée de la tête froide (3), à des composants du système de refroidissement (52) qui accomplissent des mouvements, en particulier à une vanne de commande (50) ou à un compresseur.

10. Dispositif de refroidissement (1) selon l'une des revendications précédentes, **caractérisé par le fait que** la zone (7) à température ambiante de la tête froide (3) présente, dans la région de la fixation de la zone flexible d'étanchement (13), un diamètre DM perpendiculairement à son axe longitudinal (LA) ; et **par le fait qu'**une distance AB, séparant l'axe de rotation (A) d'avec un plan d'étanchement (DE) dans lequel ladite zone flexible d'étanchement (13) est fixée à la paroi du réservoir (4) à dépression, obéit à la relation :
AB ≤ 0,4^{∗}DM, de préférence AB ≤ 0,3^{∗}DM,
sachant notamment que ledit axe de rotation (A) est situé dans ledit plan d'étanchement (DE).

11. Dispositif de refroidissement (1) selon l'une des revendications précédentes, **caractérisé par le fait que** la tête froide (3) et le cryostat (2) sont réalisés avec faculté d'ajustement mutuel le long d'un axe longitudinal (LA) de ladite tête froide.

12. Dispositif de refroidissement (1) selon l'une des revendications 1 à 11, **caractérisé par le fait que** le palier tournant (35) est conçu muni de deux tourillons (31) faisant saillie, le long de l'axe de rotation (A), vers la tête froide (3) à partir d'une zone (30) formant collerette du réservoir (4) à dépression ; et **par le fait que** lesdits tourillons (31) sont respectivement ceinturés par un roulement à billes (32), les roulements à billes (32) étant reliés rigidement à ladite tête froide (3).

13. Dispositif de refroidissement (1) selon les revendications 11 et 12, **caractérisé par le fait que** les roulements à billes (32) sont logés dans une bague de retenue (20) pouvant être ajustée par rapport à la tête froide (3), le long de l'axe longitudinal (LA) de ladite tête froide (3), par l'intermédiaire d'un ou plusieurs élément(s) d'ajustement (21).

14. Dispositif de refroidissement (1) selon l'une des revendications 1 à 11, **caractérisé par le fait que** le palier tournant (35) est conçu muni de deux appendices de support (40) faisant saillie vers la tête froide (3), à partir d'une zone (30) formant collerette du réservoir (4) à dépression ; et **par le fait que** lesdits appendices de support (40) sont pourvus d'au moins deux appuis (42) en forme de points ou de lignes, situés sur l'axe de rotation (A).

15. Dispositif de refroidissement (1) selon l'une des revendications précédentes, **caractérisé par le fait que** l'axe de rotation (A) s'étend horizontalement.

16. Agencement (70) de mesure RMN, comprenant un dispositif de refroidissement (1) conforme à l'une des revendications précédentes, un ensemble (71) de bobines magnétiques dans le conteneur cryogénique (6), ainsi qu'un résonateur HF (73) qui entoure une chambre d'échantillonnage (72) dans un alésage (74) à température ambiante du cryostat (2).
